# EUROPEAN PATENT SPECIFICATION

(11) **EP 2 430 463 B1**
(45) Date of publication and mention of the grant of the patent: **17.07.2013**
(21) Application number: 10710182.6
(22) Date of filing: 25.03.2010
(51) Int. Cl.: G01R 11/24, G01R 22/06

(54) **MAGNETICALLY IMMUNE CONSUMPTION METER**
MAGNETISCH IMMUNER VERBRAUCHSMESSER
Compteur de consommation magnétiquement immun

(30) Priority: 12.05.2009 EP 09160002
(43) Date of publication of application: 21.03.2012
(73) Proprietor: Kamstrup A/S, 8660 Skanderborg (DK)
(72) Inventor: HANSEN, Gorm, Bass, DK-8722 Hedensted (DK)
(74) Representative: Plougmann & Vingtoft A/S
(86) International application number: PCT/DK2010/050067
(87) International publication number: WO 2010/130258

(56) References cited:
- EP-A1- 0 701 139
- EP-A1- 1 962 098
- US-A1- 2004 215 243
- US-A1- 2004 215 279

## Description

### FIELD OF THE INVENTION

The invention relates to the field of consumption meters, such as consumption meters or measuring an amount of electricity, heat, cooling, gas or water. In particular the invention provides a consumption meter which is generally immune to magnetic fields. More specifically, the consumption meter has a power supply which allows the meter to function also during influence of strong magnetic fields.

### BACKGROUND OF THE INVENTION

Magnetic tampering of consumption meters, especially electrical meters, has always been an issue, since the consumer by this could affect the billing amount. On traditional Ferraris type electrical meters, based on a disc rotating by means of an electromagnetic field, a magnet placed adjacent to the meter could slow down or completely prevent the rotation, lowering the counting thus the amount to be billed.

Electronic meters on its part require a power supply for its measuring circuit. Per tradition it has been conducted via a transformer based on electromagnetic principles. Such transformer can also be influenced by adjacent magnets with the same result, because the power capacity of the power supply can be reduced significantly by a strong magnetic field due to the destroyed electromagnetic function of the transformer. Hereby, the supply power for the vital electronic measurement and calculation circuits can be too low for the circuits to function, and thus the meter will stop functioning.

One way of reducing such magnetic tampering is to magnetically shield the sensitive components including the power supply transformer, in order to reduce the magnetic field reaching these components.

WO 2008/055507 by Kamstrup A/S describes another way of reducing the magnetic tampering problem, namely an electricity meter with a switch mode power supply. A switching circuit generates a pulsating current through a primary winding of an electromagnetic transformer. Such power supply can be made rather resistant to magnetic tampering. This is due to a high switching frequency, the electromagnetic transformer can easily be dimensioned such that it is still able to deliver sufficient power for the vital meter circuits even during influence of a strong magnetic field. However, due to such dimensioning the transformer can be rather expensive, have large dimensions and have a low degree of electrical efficiency.

Another solution to the magnetic tampering p^roblem is an electricity meter with a capacitive power supply. A capacitive voltage divider is provided by means of two capacitors, hereby providing a power supply which is insensible to magnetic tampering. However, due to the required capacitor value and size of at least one of such capacitors, such power supply will typically only be used to power the most vital circuits of the meter.

Other disclosures of the prior art include:
EP 0 701 139 A1 which discloses transformers for electric voltage meters based on mechanical waves. The disclosure describes the generation of elastic waves in transformers which are composed of a transmitter, a receiver, a dielectric body and a mechanical connection; piezoelectric and electrostrictive materials are utilized to build different types of transformers depending on the structure.
EP 1 962 098 A1 which discloses an electric consumption meter with a power line switch to either connects or disconnects an electric power line. The disclosure describes an actuator to operate the change state of the switch in response to a control signal. The actuator may be based on a piezo-electric motor to obtain a magnetically immune switch function.
US 2004/0215279 which discloses an implantable medical device having a piezoelectric transformer to power a lead-based sensor. The piezoelectric transformer serves to convert the voltage level of a low amplitude signal produced by a battery in the device to a higher voltage level to drive the sensor.

### SUMMARY OF THE INVENTION

In view of the above, it may be seen as an object of the present invention to provide a consumption meter, e.g. an electricity meter, with a power supply which is magnetically immune, has a small size, which has a power capacity sufficient to power all functions relating to the meter, and which is still suited for low cost mass production.

The invention provides a consumption meter arranged to measure a consumed quantity of a physical entity in accordance with claim 1.

The term 'legal circuit' is used to denote the circuit element which are vital for the function of the meter, since in consumption meters certified for charging purposes, such circuits are bound by legal requirements. Thus, the power supply is arranged to at least provide electric power to drive the circuits responsible for the basic meter function.

A consumption meter with a power supply based on electric-to-mechanical-to-electric transformation can be implemented without involvement of any magnetically sensitive elements. Thus, the meter can be made immune to magnetic tampering, and thus the magnetic tampering problem is eliminated rather than only reduced, such as seen in prior art meters. Further, such transformation principle in the power supply can be implemented with components of compact dimensions and high efficiency, and thus it is still possible to build such components into the meter casing, e.g. inside the casing of an electricity meter, and still provide enough electric power to power all circuits related to the consumption meter, including a rather power consuming wireless Radio Frequency transmitter for remote reading purposes. Still further, such components of the power supply are rather inexpensive and thus suited for large scale, low cost production.

It is appreciated that the power supply can be integrated with the consumption meter, such as housed within the meter housing, which will typically be preferred in case of an electricity meter, or the power supply can be housed in a casing separate from the consumption meter, which may be preferred for other types of consumption meters such as heat meters or cooling meters.

The power supply comprises a piezoelectric transformer arranged to perform conversion from electric energy into mechanical energy and conversion from the mechanical energy into electric energy. Such piezoelectric transformer is rather inexpensive since it can be produced in a highly automated manufacturing process, the piezoelectric material is non-magnetic and is thus magnetically tampering immune, it can convert electric energy at a high efficiency and can thus provide a high electric power in spite of rather compact dimensions.

A piezoelectric voltage conversion element is rather easy to manufacture in a uniform quality, and compared to magnetic transformers, problems related to delicate windings are eliminated. This means that a power supply based on a piezoelectric voltage conversion element is more reliable than a corresponding supply based on a traditional transformer element.

Thus, a piezoelectric transformer is advantageous for the purpose of providing an electric-to-mechanical-to-electric conversion from one voltage to another voltage in a power supply. With comparable power capacity, a piezoelectric transformer can be smaller than a conventional electromagnetic transformer. Furthermore, a piezoelectric transformer typically exhibits a lower electromagnetic radiation level than conventional transformers. Further, due to a high electric-to-electric conversion efficiency, the piezoelectric transformer will only generate a small amount of heat, which again facilitates the fitting of such transformer within the consumption meter casing without the need for special heat dissipating measures. Still further, a piezoelectric transformer can be implemented by ceramic materials and is thus a non-flammable component.

US 6,707,235 B1 by Noliac A/S discloses an example of a piezoelectric transformer with galvanic separation between the primary and secondary electric sides. The function of a piezoelectric transformer is that an alternating voltage at the primary side is applied to a piezoelectric element which transfers the electric voltage to mechanical energy in the form of vibrations. This vibration propagates through an isolating layer to a second piezoelectric element which generates an alternating voltage in response to the vibrations.

The first and second piezoelectric elements are mechanically arranged in relation to each other with an intermediate mechanical structure, such that they vibrate at a certain natural frequency, a resonance frequency. The piezoelectric transformer provides the most efficient coupling between the primary and secondary sides for input voltages having a frequency in the range around the resonance frequency. Thus, circuits exist that serve to transfer a given electric alternating voltage, e.g. 50 or 60 Hz directly from the public electric net, to an alternating voltage suited for the specific piezoelectric transformer configuration in question, so as to provide a high electric conversion efficiency in the transformer. Piezoelectric transformers are available in versions suited to up or down transform a voltage at the primary side to a voltage at the secondary side with a conversion factor. In an embodiment of the present invention, the piezoelectric transformer is arranged to convert voltages with a suitable voltage conversion factor, such that the power supply converts the first voltage from the electric power line to the lower supply voltages at a voltage conversion factor within a range of 0.001 - 0.2.

Preferably, the piezoelectric transformer provides a galvanic separation between its primary electric side and its secondary electric side. Hereby, the power supply is suited for electricity meters, where such isolation is typically preferred or demanded.

Preferably, the piezoelectric transformer comprises a plurality of separate voltage outputs at its secondary electric side. Hereby, electric circuits in the meter requiring different supply voltage ranges can be powered from such separate voltage outputs that generate different output voltages. In one embodiment, such plurality of separate voltage outputs is galvanic separate from each other. Hereby, the transformer is suited for powering measurement circuits for separate phases of an electricity meter, where such galvanic separation is typically required. Thus, in one embodiment, the consumption meter is an electricity meter, and separate measurement circuits are arranged for performing measurements on respective electric phases of the power line, and wherein the separate measurement circuits are powered from respective ones of the separate voltage outputs. A first one of the separate voltage outputs may be arranged to generate the supply voltage to the legal circuit. A separate voltage output may be arranged to power a communication module arranged to transmit a data value representing the consumed quantity, such as a wireless Radio Frequency transmitter. Further, a separate voltage output may be arranged to power one or more auxiliary circuits, such as one or more of: a smoke detector, an alarming circuit such as a leakage alarming circuit, and a power switch etc.

Preferably, the meter comprises a switch mode driver circuit connected to a primary electric side of the piezoelectric transformer which operate at an operating frequency higher than 10 kHz, such as higher than 100 kHz. Especially, the operating frequency of the driver circuit may be selected based on a resonance frequency of the piezoelectric transformer, such as the operating frequency being selected to be within +/- 20% of the resonance frequency of the piezoelectric transformer, thus providing a high efficiency. In spite of the operating frequency of the driver circuit may be closely related to the resonance frequency of the piezoelectric transformer, the driver circuit may be designed to generate an output signal to the piezoelectric transformer which has a frequency substantially coinciding with a sub-harmonic of a resonance frequency of the piezoelectric transformer.

The switch mode driver circuit is preferably connected to the power line via a rectifier, such as via a rectifier and a filter.

The meter may comprise a regulation circuit connected to the switch mode driver circuit, such as a regulation circuit connected to the switch mode driver circuit in a feed back loop. Such regulation circuit may be connected via a feedback signal at the primary electric side of the piezoelectric transformer and a drive signal. A feed back loop may be provided between the secondary electric side and the primary electric side of the piezoelectric transformer. Especially, the regulation circuit may be arranged to receive a feedback signal from the secondary electric side of the piezoelectric transformer, e.g. based on a supply voltage output, and to generate a signal to a driver circuit connected to the primary electric side of the piezoelectric transformer.

Preferably, the power supply is arranged for connection to an electric power line providing a first voltage within the range of 100 - 500 V. Hereby, the power supply is suited for use with typical public electric nets.

The consumption meter may be an electricity meter, a heat meter, a cooling meter, a water meter, or a gas meter.

It is appreciated that two or more of the mentioned embodiments can advantageously be combined.

### BRIEF DESCRIPTION OF THE DRAWINGS

Embodiments of the invention will be described, by way of example only, with reference to the drawings, in which
Fig. 1 illustrates a block diagram of one consumption meter embodiment with a piezoelectric transformer having a single voltage output, this is suitable for a heat meter or a cooling meter,
Fig. 2 illustrates a block diagram of a 3-phase electricity meter embodiment with a piezoelectric transformer having a plurality of separate voltage outputs, and
Fig. 3 illustrates a block diagram of yet another consumption meter embodiment with a piezoelectric transformer with feedback from two of its three voltage outputs.

### DESCRIPTION OF EMBODIMENTS

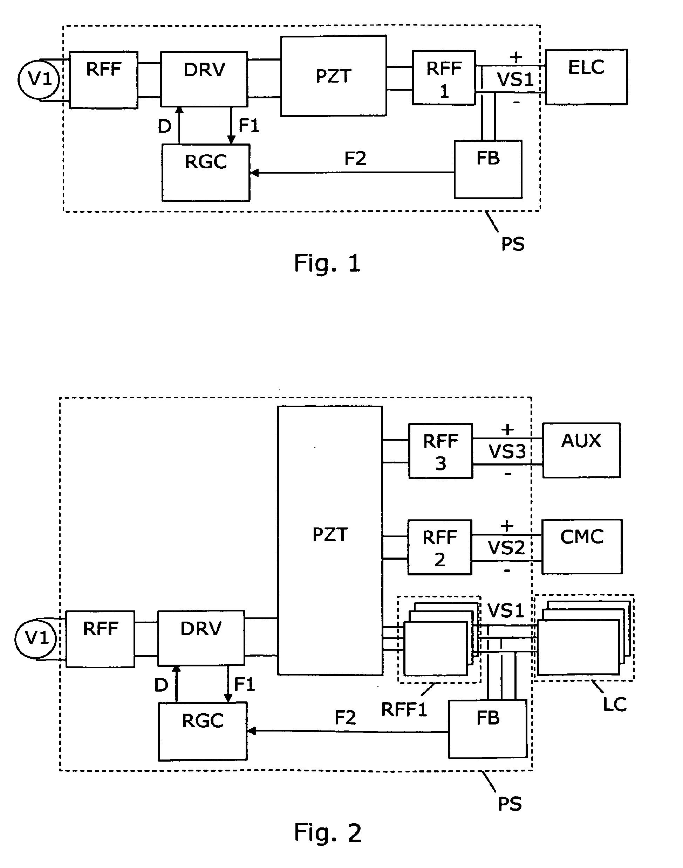

Fig. 1 shows a block diagram of selected components of a consumption meter, e.g. a heating meter or a cooling meter, illustrating details of its power supply PS which is supplied by electric power from an electric AC power line at voltage V1, e.g. the electric public net supply at V1=230 V. In this embodiment, the power supply PS has only one output voltage VS1 to power electronic circuits ELC involved in the vital meter functions, i.e. all legal circuits as well as other functions of the meter, i.e. circuits such as a Radio Frequency transmitter circuit arranged for remote reading of the consumption meter and possible auxiliary circuits. Such supply power configuration may be preferred for heating meters or cooling meters.

The power supply PS may be integrated with the consumption meter, e.g. built into the casing that houses the meter circuits, which may be preferred in case of an electricity meter. Alternatively, for heat meters and cooling meters, it may be preferred that the power supply PS has a separate casing and supplies the low voltage signal VS1 to the meter circuits ELC via an external wire.

At the AC power input of the power supply PS, a rectifier and filter circuit RFF serves to rectify and filter the AC power line voltage V1 and provide the rectified and filtered voltage to a driver circuit DRV. The driver circuit DRV is electrically connected to drive a primary electric side of a piezoelectric transformer PZT. The driver circuit DRV is especially suited to obtain a high conversion efficiency of the piezoelectric transformer PZT by driving it in the frequency range around its mechanical resonance frequency, this resonance frequency being determined by the mechanical configuration of the piezoelectric transformer, but which is also influenced by the load of the piezoelectric transformer. In fact the resonance frequency depends both on the load on the primary and secondary electric sides of the transformer. The driver circuit DRV is typically in the form of a switch mode circuit operating at an operating frequency in the 50 kHz, 100 kHz or even higher, e.g. selected at or at least near the resonance frequency of the piezoelectric transformer PZT. However, the driver circuit DRV may generate an output signal, e.g. in the form of pulses, to drive the primary electric side of the piezoelectric transformer PZT which has a frequency at or near a sub-harmonic of the resonance frequency of the piezoelectric transformer PZT. By driving the primary electric side of the piezoelectric transformer PZT at or near a sub-harmonic of its resonance frequency, it is ensured that driving pulses are applied at time instants where they support the mechanical vibration of the piezoelectric transformer PZT.

The embodiment of Fig. 1 has a piezoelectric transformer PZT with a single voltage-to-voltage conversion element and thus a single voltage output, resulting in a single voltage output VS1 from the power supply PS. A rectifier and a filter circuit RFF1 are provided to rectify and filter the electric output from the transformer PZT and provide a DC voltage VS1 suited to drive the electronic circuits ELC of the meter, e.g. a DC voltage such as 3.6 V, 5 V or 10 V, or the like.

A feedback is provided between the secondary and primary electric sides of the piezoelectric transformer PZT in order to control the driver circuit DRV to provide a stable voltage VS1. This feedback is illustrated as a feedback interface FB connected to sense the output voltage VS1. The feedback interface FB provides a feedback signal F2 to a regulation circuit RGC which is connected to the driver circuit DRV in a feedback loop by providing a drive signal D to the driver circuit DRV and by receiving in response a feedback signal F1 from the driver circuit DRV.

Especially, the driver circuit DRV may, indirectly via the regulation circuit RGC and drive signal D, adjust its operating frequency in response to the feedback F2 from the secondary electric side of the piezoelectric transformer PZT, and further the driver circuit DRV may be arranged to adjust the frequency of its output signal to drive the piezoelectric transformer in response to the feedback F2 from the secondary electric side. The feedback signal F2 may be used by the driver circuit DRV to synchronize the frequency of its output signal to drive the piezoelectric transformer PZT in response to a detected resonance frequency of the piezoelectric transformer PZT, since the resonance frequency of the piezoelectric transformer PZT will typically vary according to the load of its secondary electric side.

Fig. 2 illustrates a configuration typical for a 3-phase electricity meter. Galvanic separate secondary electric outputs from the piezoelectric transformer PZT are used to provide separate voltage outputs VS1, VS2, VS3 from the power supply PS. Especially, it is seen that the legal circuits LC involved in the vital meter functions are separated into three circuits, one for each electric phase, and thus the voltage output VS1 is separated into three galvanic separate outputs, one for the circuit for each electric phase. At each of the secondary electric outputs of the piezoelectric transformer PZT, respective rectifier and filter circuits RFF1, RFF2, RFF3 are connected to rectify and filter the electric outputs from the transformer PZT and provide DC voltages VS1, VS2, VS3. These DC voltages VS1, VS2, VS3 are suited to, respectively, drive 1) the legal circuits LC involved in the vital meter functions such as measurement circuit, calculator circuit, display etc., 2) communication circuits CMC, e.g. a wireless Radio Frequency communication module, and 3) auxiliary circuits AUX e.g. a smoke detector etc. The DC voltages VS1, VS2, VS3 may be different or they may represent the same voltage levels.

A feedback is provided between the secondary and primary electric sides of the piezoelectric transformer PZT in order to control the driver circuit DRV to provide stable voltages VS1, VS2, VS3. In this embodiment, this feedback is illustrated as a feedback interface FB connected to sense only one of the three output voltages, namely VS1 used to drive the legal circuits LC. Especially, it is seen that the feedback interface FB is connected to sense all three separate voltage outputs VS1, however it may be preferred only to provide feedback from a selected one of the three outputs of VS1.

As also illustrated and described in relation to Fig. 1, the feedback interface FB provides a feedback signal F2 accordingly to a regulation circuit RGC which is connected to the driver circuit DRV in a feedback loop by providing a drive signal D to the driver circuit DRV and by receiving in response a feedback signal F1 from the driver circuit DRV. Preferably, the feedback F2 between the secondary and primary electric sides of the piezoelectric transformer PZT is based on the secondary electric output powering the most power demanding ones of the circuits LC, CMC, AUX. In some cases this may be the communication circuit CMC which in RF transmission mode can be rather power consuming. However, since the communication circuits CMC is only active in short intervals, in the embodiment of Fig. 2 is has been chosen to select VS1, i.e. the legal circuit LC supply voltage, to provide the feedback signal F2, since hereby a feedback signal F2 will always be available because the legal circuits LC are always active.

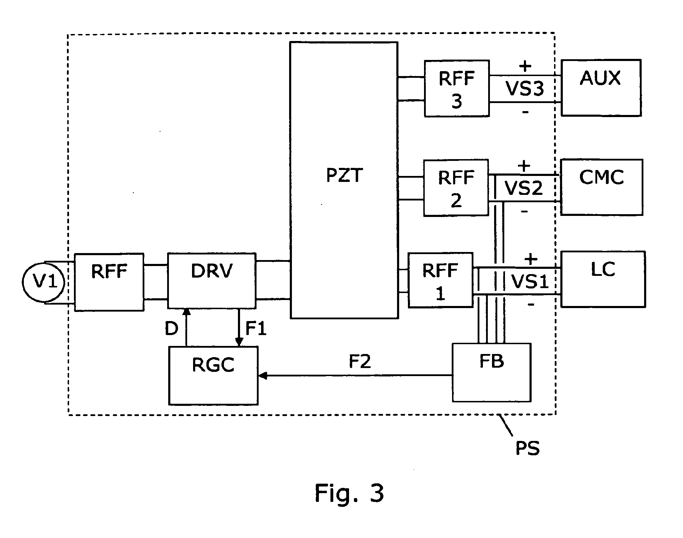

Fig. 3 illustrates a slightly different version of the embodiment of Fig. 2, e.g. as can be used for a one-phase electricity meter. As seen, the difference between the embodiments of Fig. 2 and 3 is the feedback from the secondary electric side of the piezoelectric transformer PZT. In Fig. 3, the feedback interface FB is arranged to generate a feedback signal F2 in response to an input in the form of both of the first and second supply voltages VS1, VS2, i.e. the supply voltages to the legal circuits LC and the communication circuits CMC, which may be different DC voltage levels. Hereby, it is possible to provide a feedback signal F2 from the secondary electric side of the piezoelectric transformer PZT which takes into account both the rather constant load from the legal circuits LC as well as the short term heavy load from the communication circuits CMC.

Typically, the output voltages required to drive the circuits LC, CMC, AUX are below 20 V, e.g. below 10 V. Thus, the power supply PS may thus provide voltage-to-voltage conversion factors such as approximately below 0.05 in case of a 230 V AC power input V1. To obtain this voltage conversion for the power supply PS, the piezoelectric transformer PZT is selected to have a suitable voltage step down factor.

As already mentioned, a piezoelectric transformer PZT suited for a power supply PS in a consumption meter is commercially available. A suitable driver circuit DRV fitting an actual piezoelectric transformer PZT and an actual application, e.g. in the form of an ASIC, should be designed especially according to the specific conditions, in order to provide a high conversion efficiency. However, by careful design of the driver circuit DRV and with the use of feedback F1, F2 from both of the primary and secondary electric sides of the piezoelectric transformer PZT, it is possible to obtain a power supply PS providing a high voltage-to-voltage conversion efficiency.

In a preferred embodiment, the power supply PS is built into the casing of an electricity meter, e.g. a three-phase electricity meter, where galvanic separate secondary electric side outputs are provided from the piezoelectric transformer to drive separate measurement circuits for each of the three electric phases.

To sum up, the invention provides a consumption meter comprising a legal circuit for measuring a physical parameter of a physical entity and for generating a consumed quantity accordingly. The meter comprises a power supply for powering at least the legal circuit. The power supply is arranged to convert a first voltage from an electric power line into a lower supply voltage, wherein the conversion from the first voltage to the lower supply voltage involves conversion from electric energy into mechanical energy and conversion from the mechanical energy into electric energy. Such meter, e.g. an electricity meter, is suitable to provide a magnetically tampering immune consumption meter. Preferably, the power supply comprises a piezoelectric transformer to provide this conversion. Such transformer is magnetically immune, rather inexpensive, small, and can provide a high conversion efficiency, thus making such type of transformer suited to built into the casing of a compact consumption meter, e.g. an electricity meter. Although the present invention has been described in connection with preferred embodiments, it is not intended to be limited to the specific form set forth herein. Rather, the scope of the present invention is limited only by the accompanying claims.

## Claims

1. A consumption meter arranged to measure a consumed quantity of a physical entity, the meter comprising
- a legal circuit (LC) involved in performing a measurement of a physical parameter related to the physical entity and to generate a quantity value representing the consumed quantity accordingly, and
- a power supply (PS) arranged for connection to an electric power line providing a first voltage (V1) within the range of 50 - 1000 V and arranged for powering at least the legal circuit (LC), wherein the power supply (PS) is arranged to convert the first voltage (V1) from an electric power line into a lower supply voltage (VS1),
**characterized in that** the power supply comprises
a piezoelectric transformer (PZT) arranged to convert the first voltage (V1) to the supply voltage (VS1) by converting electric energy into mechanical energy and conversion from the mechanical energy into electric energy, where a switch mode driver circuit (DRV) is connected to a primary electric side of the piezoelectric transformer (PZT) and the legal circuit is connected to the secondary side of the piezoelectric transformer (PZT), and wherein a feed back is provided from the secondary electric side to the primary electric side of the piezoelectric transformer, in order to adjust the operating frequency in response to a feedback signal.

2. Consumption meter according to claim 1, wherein the piezoelectric transformer (PZT) exhibits a voltage-to-voltage conversion so as to provide a conversion factor for the power supply (PS) from the first voltage (V1) from the electric power line to the lower supply voltage (VS1) within a range of 0.001 - 0.2.

3. Consumption meter according to claim 1 or 2, wherein the piezoelectric transformer (PZT) provides a galvanic separation between its primary electric side and its secondary electric side.

4. Consumption meter according to any of the preceding claims, wherein the piezoelectric transformer (PZT) has a single voltage output (VS1) for powering all power demanding circuits (ELC) of the consumption meter.

5. Consumption meter according to any of claims 1-3, wherein the piezoelectric transformer (PZT) comprises a plurality of separate voltage outputs (VS1, VS2, VS3) at its secondary electric side.

6. Consumption meter according to claim 5, wherein at least two of the plurality of separate voltage outputs (VS1, VS2, VS3) are galvanic separate from each other.

7. Consumption meter according to claim 5 or 6, wherein a first one of the separate voltage outputs (VS1) is arranged to generate the supply voltage to the legal circuit (LC).

8. Consumption meter according to any of claims 5-7, wherein a separate voltage output (VS2) is arranged to power a communication module (CMC) arranged to transmit a data value representing the consumed quantity.

9. Consumption meter according to any of claims 5-8, wherein a separate voltage output (VS3) is arranged to power one or more auxiliary circuits selected from the group of: a smoke detector, an alarming circuit, and a power switch.

10. Consumption meter according to any of the preceding claims, wherein the switch mode driver circuit (DRV) is arranged to operate at an operating frequency higher than 10 kHz.

11. Consumption meter according to any of the preceding claims, wherein the switch mode driver circuit (DRV) is arranged to operated at an operating frequency substantially coinciding with a sub-harmonic of a resonance frequency of the piezoelectric transformer (PZT).

12. Consumption meter according to claim 10, wherein the operating frequency of the driver circuit (DRV) is selected based on a resonance frequency of the piezoelectric transformer (PZT) to be within +/- 20% of the resonance frequency of the piezoelectric transformer (PZT).

13. Consumption meter according to any of the preceding claims, wherein the switch mode driver circuit (DRV) is connected to the power line via a rectifier (RFF).

14. Consumption meter according to any of any of the preceding claims, comprising a regulation circuit (RGC) connected to the switch mode driver circuit (DRV).

15. Consumption meter according to any of the preceding claims, being one of: an electricity meter, a heat meter, a cooling meter, a water meter, and a gas meter.

## Patentansprüche

1. Verbrauchsmessgerät, angeordnet zum Messen einer verbrauchten Menge eines physikalischen Phänomens, wobei das Messgerät umfasst
- einen gesetzlich vorgeschriebenen Schaltkreis (LC), der an der Durchführung einer Messung eines mit dem physikalischen Phänomen in Verbindung stehenden physikalischen Parameters und der Generierung eines Mengenwerts, der eine entsprechende Repräsentation der verbrauchten Menge darstellt, beteiligt ist und
- Stromversorgung (PS), die zum Anschluss an eine Netzleitung angeordnet ist, die eine erste Spannung (V1) im Bereich von 50-1000 V bereitstellt und die zur Stromversorgung mindestens des gesetzlich vorgeschriebenen Schaltkreises (LC) angeordnet ist, wobei die Stromversorgung (PS) zum Umwandeln der ersten Spannung (V1) von einer Netzleitung in eine niedrigere Versorgungsspannung (VS1) angeordnet ist,
**dadurch gekennzeichnet, dass** die Stromversorgung umfasst
einen piezoelektrischen Transformator (PZT), der zum Umwandeln der ersten Spannung (V1) in die Versorgungsspannung (VS1) durch Umwandeln elektrischer Energie in mechanische Energie und Umwandeln von mechanischer Energie in elektrische Energie angeordnet ist, wobei ein Treiber-Schaltkreis (DRV) mit einer primären elektrischen Seite des piezoelektrischen Transformators (PZT) verbunden ist und der gesetzlich vorgeschriebene Schaltkreis mit der sekundären Seite des piezoelektrischen Transformators (PZT) verbunden ist und wobei von der sekundären elektrischen Seite eine Rückkopplung zur primären elektrischen Seite des piezoelektrischen Transformators bereitgestellt wird, um die Betriebsfrequenz als Reaktion auf ein Rückkopplungssignal anzupassen.

2. Verbrauchsmessgerät nach Anspruch 1, wobei der piezoelektrische Transformator (PZT) eine Spannung-zu-Spannung-Umwandlung aufweist, mit der ein Umwandlungsfaktor für die Stromversorgung (PS) von der ersten Spannung (V1) von einer Netzleitung in eine niedrigere Versorgungsspannung (VS1) im Bereich von 0,001-0,2 bereitgestellt wird.

3. Verbrauchsmessgerät nach Anspruch 1 oder 2, wobei der piezoelektrische Transformator (PZT) eine galvanische Trennung zwischen seiner primären elektrischen Seite und seiner sekundären elektrischen Seite bereitstellt.

4. Verbrauchsmessgerät nach einem der vorhergehenden Ansprüche, wobei der piezoelektrische Transformator (PZT) einen einzigen Spannungsausgang (VS1) zur Versorgung aller leistungsabhängigen Schaltkreise (ELC) des Verbrauchsmessgeräts aufweist.

5. Verbrauchsmessgeräte nach einem der Ansprüche 1-3, wobei der piezoelektrische Transformator (PZT) eine Mehrzahl von getrennten Spannungsausgängen (VS1, VS2, VS3) auf seiner sekundären elektrischen Seite aufweist.

6. Verbrauchsmessgerät nach Anspruch 5, wobei mindestens zwei der Mehrzahl der getrennten Spannungsausgänge (VS1, VS2, VS3) galvanisch voneinander getrennt sind.

7. Verbrauchsmessgerät nach Anspruch 5 oder 6, wobei ein erster der getrennten Spannungsausgänge (VS1) zum Erzeugen der Versorgungsspannung des gesetzlich vorgeschriebenen Schaltkreises (LC) angeordnet ist.

8. Verbrauchsmessgerät nach einem der Ansprüche 5-7, wobei ein getrennter Spannungsausgang (VS2) zur Versorgung eines Kommunikationsmoduls (CMC) angeordnet ist, das zum Übertragen eines die verbrauchte Menge repräsentierenden Datenwerts angeordnet ist.

9. Verbrauchsmessgerät nach einem der Ansprüche 5-8, wobei ein getrennter Spannungsausgang (VS3) zur Versorgung eines oder mehrerer Schaltkreise angeordnet ist, ausgewählt aus der Gruppe, bestehend aus: Rauchmelder, Alarmschaltkreis und Netzschalter.

10. Verbrauchsmessgerät nach einem der vorhergehenden Ansprüche, wobei der Motortreiber-Schaltkreis (DRV) zum Betrieb bei einer Betriebsfrequenz von mehr als 10 kHz angeordnet ist.

11. Verbrauchsmesser nach einem der vorhergehenden Ansprüche, wobei der Motortreiber-Schaltkreis (DRV) zum Betrieb bei einer Betriebsfrequenz angeordnet ist, die im Wesentlichen mit einer harmonischen Teilschwingung einer Resonanzfrequenz des piezoelektrischen Transformators (PZT) zusammenfällt.

12. Verbrauchsmessgerät nach Anspruch 10, wobei die Betriebsfrequenz des Treiber-Schaltkreises (DRV) auf der Grundlage einer Resonanzfrequenz des piezoelektrischen Transformators (PZT) innerhalb von +/-20 % der Resonanzfrequenz des piezoelektrischen Transformators (PZT) ausgewählt ist.

13. Verbrauchsmessgerät nach einem der vorhergehenden Ansprüche, wobei der Motortreiber-Schaltkreis (DRV) über einen Gleichrichter mit der Netzleitung verbunden ist.

14. Verbrauchsmessgerät nach einem der vorhergehenden Ansprüche, umfassend einen Regelschaltkreis (RGC), der mit dem Treiber-Schaltkreis (DRV) verbunden ist.

15. Verbrauchsmessgerät nach einem der vorhergehenden Ansprüche, das eines von Folgenden ist: ein Stromzähler, ein Wärmezähler, ein Kältezähler, ein Wasserzähler und ein Gaszähler.

## Revendications

1. Compteur de consommation conçu pour mesurer une quantité consommée d'une entité physique, le compteur comprenant
- un circuit légal (LC) intervenant dans la réalisation d'une mesure d'un paramètre physique relatif à l'entité physique et dans la production d'une valeur quantitative représentant la quantité consommée correspondante, et
- une alimentation électrique (PS) conçue pour être raccordée à une ligne d'alimentation électrique fournissant une première tension (V1) située dans la plage de 50 à 1000 V et conçue pour alimenter au moins le circuit légal (LC), dans lequel l'alimentation électrique (PS) est conçue pour convertir la première tension (V1) provenant d'une ligne d'alimentation électrique en une tension (VS1) d'alimentation inférieure,
**caractérisé en ce que** l'alimentation électrique comprend
un transformateur piézoélectrique (PZT) conçu pour convertir la première tension (V1) en tension (VS1) d'alimentation en convertissant l'énergie électrique en énergie mécanique et par conversion de l'énergie mécanique en énergie électrique, dans lequel un circuit d'attaque à découpage (DRV) est raccordé à un côté électrique primaire du transformateur piézoélectrique (PZT) et le circuit légal est raccordé au côté secondaire du transformateur piézoélectrique (PZT), et dans lequel une rétroaction est assurée du côté électrique secondaire vers le côté électrique primaire du transformateur piézoélectrique, afin d'ajuster la fréquence de fonctionnement en réponse à un signal de retour.

2. Compteur de consommation selon la revendication 1, dans lequel le transformateur piézoélectrique (PZT) assure une conversion tension-tension de manière à obtenir pour l'alimentation électrique (PS) un facteur de conversion de la première tension (V1) provenant de la ligne d'alimentation électrique en tension (VS1) d'alimentation inférieure situé dans une plage de 0,001 à 0,2.

3. Compteur de consommation selon la revendication 1 ou 2, dans lequel le transformateur piézoélectrique (PZT) est doté d'une séparation électrique entre son côté électrique primaire et son côté électrique secondaire.

4. Compteur de consommation selon l'une quelconque des revendications précédentes, dans lequel le transformateur piézoélectrique (PZT) possède une seule sortie de tension (VS1) pour alimenter tous les circuits (ELC) demandeurs d'énergie du compteur de consommation.

5. Compteur de consommation selon l'une quelconque des revendications 1 à 3, dans lequel le transformateur piézoélectrique (PZT) comprend plusieurs sorties de tension (VS1, VS2, VS3) séparées au niveau de son côté électrique secondaire.

6. Compteur de consommation selon la revendication 5, dans lequel au moins deux des plusieurs sorties de tension (VS1, VS2, VS3) séparées sont galvaniquement séparées les unes des autres.

7. Compteur de consommation selon la revendication 5 ou 6, dans lequel une première des sorties de tension (VS1) séparées est conçue pour produire la tension d'alimentation du circuit légal (LC).

8. Compteur de consommation selon l'une quelconque des revendications 5 à 7, dans lequel une sortie de tension (VS2) séparée est conçue pour alimenter un module de communication (CMC) conçu pour transmettre une valeur de donnée représentant la quantité consommée.

9. Compteur de consommation selon l'une quelconque des revendications 5 à 8, dans lequel une sortie de tension (VS3) séparée est conçue pour alimenter un ou plusieurs circuits auxiliaires choisis dans le groupe consistant en : un détecteur de fumée, un circuit d'alarme et un interrupteur d'alimentation.

10. Compteur de consommation selon l'une quelconque des revendications précédentes, dans lequel le circuit d'attaque à découpage (DRV) est conçu pour fonctionner à une fréquence de fonctionnement supérieure à 10 kHz.

11. Compteur de consommation selon l'une quelconque des revendications précédentes, dans lequel le circuit d'attaque à découpage (DRV) est conçu pour fonctionner à une fréquence de fonctionnement coïncidant pour l'essentiel avec une sous-harmonique d'une fréquence de résonance du transformateur piézoélectrique (PZT).

12. Compteur de consommation selon la revendication 10, dans lequel la fréquence de fonctionnement du circuit d'attaque(DRV) est choisie sur la base d'une fréquence de résonance du transformateur piézoélectrique (PZT) de manière à se situer dans la limite de +/- 20 % de la fréquence de résonance du transformateur piézoélectrique (PZT).

13. Compteur de consommation selon l'une quelconque des revendications précédentes, dans lequel le circuit d'attaque à découpage (DRV) est raccordé à la ligne d'alimentation par l'intermédiaire d'un redresseur (RFF).

14. Compteur de consommation selon l'une quelconque des revendications précédentes, comprenant un circuit de régulation (RGC) raccordé au circuit d'attaque à découpage (DRV).

15. Compteur de consommation selon l'une quelconque des revendications précédentes, étant de l'un des types suivants : compteur d'électricité, compteur de chaleur, compteur de refroidissement, compteur d'eau et compteur à gaz.
